# EUROPEAN PATENT APPLICATION

(11) **EP 4 598 305 A2**
(43) Date of publication of application: **06.08.2025**
(21) Application number: 25154051.4
(22) Date of filing: 27.01.2025
(51) Int. Cl.: H10D 84/01, H10D 30/01, H10D 30/43, H10D 30/00, H10D 84/03, H10D 84/85, H10D 88/00

(54) **SEMICONDUCTOR DEVICE INCLUDING DIFFERENT INNER SPACERS**

(30) Priority: 05.02.2024 US 202463549857 P; 27.06.2024 US 202418756407
(71) Applicant: Samsung Electronics Co., Ltd., Suwon-si, Gyeonggi-do 16677 (KR)
(72) Inventor: PARK, Keumseok, San Jose, CA 95134 (US); LEE, Jaehong, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

Provided is a semiconductor device which includes: a plurality of 1^{st} channel layers arranged in a 1^{st} direction; a 1^{st} source/drain region on the plurality of 1^{st} channel layers; a 1^{st} gate structure including a 1^{st} inner gate structure between two adjacent 1^{st} channel layers among the plurality of 1^{st} channel layers; and a 1^{st} inner spacer between the 1^{st} inner gate structure and the 1^{st} source/drain region, wherein the 1^{st} inner spacer has a greater thickness than the 1^{st} inner gate structure in the 1^{st} direction. For example, a top surface of the 1^{st} inner spacer may be at a higher level than a top surface of the 1^{st} inner gate structure, and a bottom surface of the 1^{st} inner spacer may be at a lower level than a bottom surface of the 1^{st} inner gate structure, in the 1^{st} direction.

## Description

### BACKGROUND

### 1. Field

Apparatuses and methods consistent with the disclosure relate to a semiconductor device in which thick inner spacers are formed.

### 2. Description of Related Art

Increased demand for high device density and performance for semiconductor devices have introduced the nanosheet transistor, and further, a three-dimensionally-stacked (3D-stacked) semiconductor device in which two or more nanosheet transistors are vertically stacked.

The nanosheet transistor is characterized by one or more nanosheet channel layers vertically stacked on a substrate as a channel structure and a gate structure surrounding all four surfaces of each of the nanosheet channel layers. The nanosheet transistor is known to allow a better control of a current and enable a higher device density than other types of transistor such as fin-field effect transistor (FinFET) in forming a semiconductor device. The nanosheet transistor is also referred to as gate-all-around (GAA) transistor, or as a multi-bridge channel field-effect transistor (MBCFET).

Researches are active to further improve the performance of the semiconductor device including the nanosheet transistors.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

According to an aspect of example embodiments, there is provided a semiconductor device which may include: a plurality of 1^{st} channel layers arranged in a 1^{st} direction; a 1^{st} source/drain region on the plurality of 1^{st} channel layers; a 1^{st} gate structure including a 1^{st} inner gate structure between two adjacent 1^{st} channel layers among the plurality of 1^{st} channel layers; and a 1^{st} inner spacer between the 1^{st} inner gate structure and the 1^{st} source/drain region, wherein a top surface of the 1^{st} inner spacer is at a higher level than a top surface of the 1^{st} inner gate structure, and a bottom surface of the 1^{st} inner spacer is at a lower level than a bottom surface of the 1^{st} inner gate structure, in the 1^{st} direction.

According to an aspect of example embodiments, there is provided a semiconductor device which may include: a plurality of 1^{st} channel layers arranged in a 1^{st} direction; a 1^{st} source/drain region on the plurality of 1^{st} channel layers; a 1^{st} gate structure including a 1^{st} inner gate structure between two adjacent 1^{st} channel layers among the plurality of 1^{st} channel layers; and a 1^{st} inner spacer between the 1^{st} inner gate structure and the 1^{st} source/drain region, wherein the 1^{st} inner spacer has a greater thickness than the 1^{st} inner gate structure in the 1^{st} direction.

According to an aspect of example embodiments, there is provided a semiconductor device which may include: a 1^{st} channel layer; a 1^{st} source/drain region on the 1^{st} channel layer; a 1^{st} gate structure including a plurality of 1^{st} inner gate structures surrounding the 1^{st} channel layer; and a plurality of 1^{st} inner spacers at sides of the plurality of 1^{st} inner gate structures, respectively, wherein the 1^{st} channel layer penetrates into the 1^{st} source/drain region through two adjacent 1^{st} inner spacers among the plurality of 1^{st} inner spacers.

According to an aspect of example embodiments, there is provided a method of manufacturing a semiconductor device. The method may include: forming a 1^{st} channel stack including a plurality of 1^{st} sacrificial layers and 1^{st} channel layers alternatingly stacked in a 1^{st} direction; performing a 1^{st} patterning on a side surface of each of the 1^{st} sacrificial layer to form a 1^{st} recess; performing a 2^{nd} patterning on the 1^{st} recess to form a 2^{nd} recess by enlarging the 1^{st} recess at least in the 1^{st} direction; forming a 1^{st} inner spacer in the 2^{nd} recess; performing a 3^{rd} patterning on a side surface of the 1^{st} inner spacer to form a 3^{rd} recess; forming a 1^{st} source/drain region based on the 1^{st} channel layers; and replacing the 1^{st} sacrificial layers with a 1^{st} gate structure.

According to an aspect of example embodiments, there is provided a method of manufacturing a semiconductor device. The method may include: forming a 1^{st} channel stack including a plurality of 1^{st} sacrificial layers and 1^{st} channel layers alternatingly stacked in a 1^{st} direction; performing a 1^{st} patterning on a side surface of each of the 1^{st} sacrificial layer to form a 1^{st} recess such that a top edge of the 1^{st} recess is at a higher level than a top surface of a 1^{st} sacrificial layer, among the plurality of 1^{st} sacrificial layers, exposed by the 1^{st} recess, and a bottom edge of the 1^{st} recess is at a lower level than a bottom surface of the 1^{st} sacrificial layer; forming a 1^{st} inner spacer in the 1^{st} recess such that the 1^{st} inner spacer partially fills the 1^{st} recess, and a top surface and a bottom surface of the 1^{st} inner spacer contact the top edge and the bottom edge of the 1^{st} recess, respectively; forming a 1^{st} source/drain region based on the 1^{st} channel layers; and replacing the 1^{st} sacrificial layers with a 1^{st} gate structure.

### BRIEF DESCRIPTION OF DRAWINGS

Example embodiments of the disclosure will be more clearly understood from the following detailed description taken in conjunction with the accompanying drawings.
FIGS. 1A-1D illustrate a 3D-stacked semiconductor device formed of nanosheet transistors, according to one or more embodiments.
FIG. 1E is an enlarged view of a portion A shown in FIG. 1A.
FIG. 1F illustrates the portion A at an intermediate step of manufacturing the semiconductor device of FIGS. 1A-1D.
FIG. 2A illustrates a 3D-stacked semiconductor device formed of nanosheet transistors including thick inner spacers, according to one or more other embodiments.
FIG. 2B is an enlarged view of a portion B shown in FIG. 2A.
FIG. 2C is a view of the portion B at an intermediate step of manufacturing the semiconductor device of FIG. 2A.
FIGS. 3A through 3L illustrate cross-section views of intermediate 3D-stacked semiconductor devices after respective steps of manufacturing a 3D-stacked semiconductor device formed of nanosheet transistors including thick inner spacers, according to one or more other embodiments.
FIGS. 4A and 4B illustrate a flowchart of a method of manufacturing a 3D-stacked semiconductor device formed of nanosheet transistors including thick inner spacers in reference to FIGS. 3A-3L, according to one or more other embodiments.
FIG. 5 is a schematic block diagram illustrating an electronic device including a semiconductor device in which improved inner spacers are formed, according to one or more embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. For example, a 1^{st} element and a 3^{rd} direction described in the description of an embodiment could be termed a 2^{nd} element and a 1^{st} direction in claims, not being limited thereto, without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

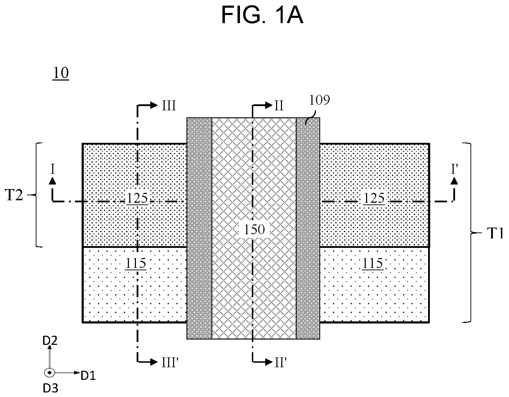

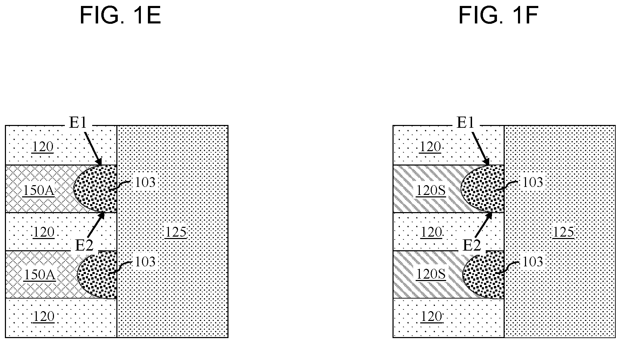

FIGS. 1A-1D illustrate a 3D-stacked semiconductor device formed of nanosheet transistors, according to one or more embodiments. FIG. 1E is an enlarged view of a portion A shown in FIG. 1A, and FIG. 1F is a view of the portion A at an intermediate step of manufacturing the semiconductor device of FIGS. 1A-1D.

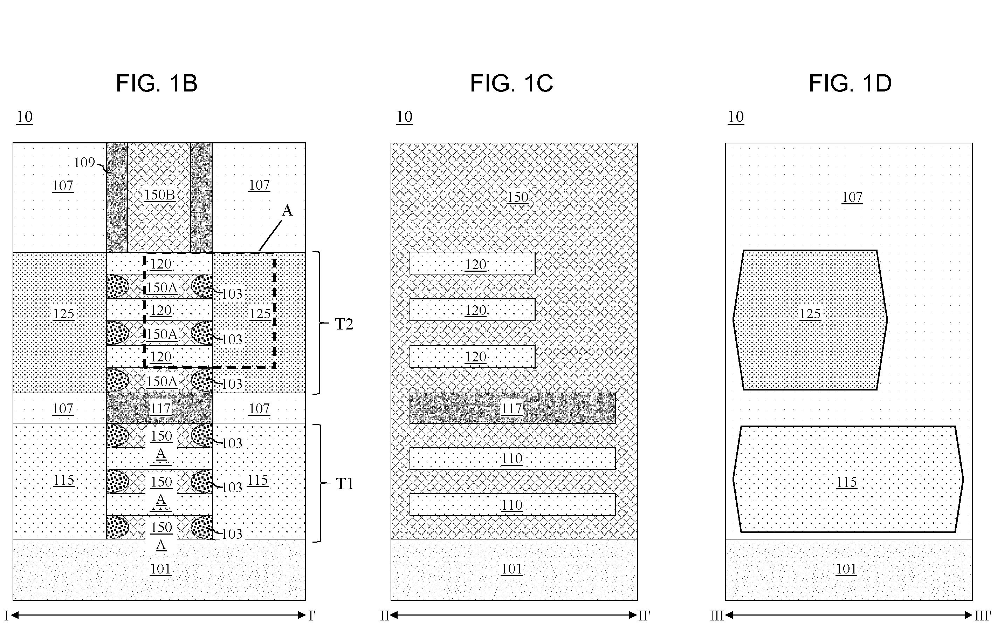

FIG. 1A is a plan view of a 3D-stacked semiconductor device 10, and FIGS. 1B-1D are cross-section views of the 3D-stacked semiconductor device 10 shown in FIG. 1A taken along lines I-I', II-II' and III-III, respectively. It is to be understood here that FIG. 1A is provided to show a positional relationship between selected structural elements of the 3D-stacked semiconductor device 10, and thus, some structural elements such as a substrate and an isolation structure shown in FIGS. 1B-1D are not shown in FIG. 1A.

As shown in FIG. 1A, a D1 direction is a channel-length direction in which a current flows between two source/drain regions connected to each other through a channel structure, a D2 direction is a channel-width direction or a cell-height that intersects the D1 direction, and a D3 direction is a vertical direction that intersects the D1 and D2 directions both of which are horizontal directions.

Referring to FIGS. 1A-1D, the 3D-stacked semiconductor device 10 may include a plurality of 1^{st} channel layers 110 arranged in the D3 direction to form a 1^{st} channel structure at a 1^{st} level on a substrate 101. The 3D-stacked semiconductor device 10 may also include a plurality of 2^{nd} channel layers 120 arranged in the D3 direction to form a 2^{nd} channel structure at a 2^{nd} level above the 1^{st} level. The channel layers 110 and 120 may also be referred to as nanosheet layers herein. A middle isolation structure 117 may be formed between the 1^{st} channel structure formed of 1^{st} channel layers 110 and the 2^{nd} channel structure formed on the 2^{nd} channel layers 120.

The substrate 101 may be a silicon (Si) substrate although it may include other materials such as silicon germanium (SiGe), silicon carbide (SiC), not being limited thereto. The channel layers 110 and 120 may have been epitaxially grown from the substrate 101 in manufacturing the 3D-stacked semiconductor device 10, and may be formed of silicon (Si) or silicon germanium (SiGe). The middle isolation structure 117 between the two channel structures may be formed of silicon nitride (e.g., SiN, SiBCN, SiCN, SiOCN, etc.).

The 1^{st} channel layers 110 may connect 1^{st} source/drain regions 115 to each other so that a current flows therebetween at a control of a gate structure 150 which surrounds each of the 1^{st} channel layers 110. Similarly, the 2^{nd} channel layers 120 may connect 2^{nd} source/drain regions 125 to each other so that a current flows therebetween at a control of the gate structure 150 which surrounds each of the 2^{nd} channel layers 120.

Thus, in the 3D-stacked semiconductor device 10, the 1^{st} channel layers 110 along with the 1^{st} source/drain regions 115 and the gate structure 150 may form a 1^{st} transistor T1, which is a lower nanosheet transistor, at the 1^{st} level. Further, the 2^{nd} channel layers 120 along with the 2^{nd} source/drain regions 125 and the gate structure 150 may form a 2^{nd} transistor T2, which is also an upper nanosheet transistor, at the 2^{nd} level.

The 1^{st} source/drain regions 115 may have been epitaxially grown from the 1^{st} channel layers 110, and the 2^{nd} source/drain regions 125 may have been epitaxially grown from the 2^{nd} channel layers 120. The 1^{st} source/drain regions 115 may be formed of silicon (Si) doped with n-type impurities such as phosphorus (P), arsenic (As), antimony (Sb), etc. to form the 1^{st} transistor T1 as an n-type transistor. The 2^{nd} source/drain regions 125 may be formed of silicon germanium (SiGe) doped with p-type impurities such as boron (B), gallium (Ga), indium (In), etc., to form the 2^{nd} transistor T2 as a p-type transistor. The disclosure is not limited thereto, however, and the 1^{st} transistor T1 may be formed as a p-type and the 2^{nd} transistor T2 may be formed as an n-type, or both of the two transistors T1 and T2 may be formed as either a p-type or an n-type.

An isolation structure 107 may be formed to surround the source/drain regions 115 and 125 to isolate these semiconductor structures from each other and other circuit elements. The isolation structure 107 may be formed of a low-k dielectric material such as silicon oxide (e.g., SiO₂).

The gate structure 150 may include an inner gate structure 150A and an outer gate structure 150B. The inner gate structure 150A may be interposed between two adjacent channel layers 110 or 120 and between the lowermost 1^{st} channel layer 110 and the substrate 101. The outer gate structure 150B may be formed outside a profile of the channel layers 110 and 120.

Further, the gate structure 150 may formed of a gate dielectric layer, a work-function metal layer, and a gate electrode. The gate dielectric layer may be formed on each of the channel layers 110 and 120, and include an interfacial layer formed of an oxide material such as silicon oxide (e.g., SiO, SiO₂, etc.) and/or silicon oxynitride (e.g., SiON), not being limited thereto. The gate dielectric layer may also include a high-k layer formed of a high-k material such as hafnium (Hf), aluminum (Al), zirconium (Zr), lanthanum (La), magnesium (Mg), barium (Ba), titanium (Ti), lead (Pb), and/or a combination thereof, not being limited thereto. The work-function metal layer may be formed on the gate dielectric layer and include of a metal such as copper (Cu), Al, Ti, tantalum (Ta), tungsten (W), cobalt (Co), TiN, WN, TiAl, TiAlN, TaN, TiC, TaC, TiAlC, TaCN, TaSiN, and/or a combination thereof, not being limited thereto. However, the work-function metal layers of the gate structure 150 may be different from each other in the case where the 1^{st} transistor T1 is of an n-type and the 2^{nd} transistor T2 is of a p-type so that they may have different gate threshold voltages. The gate electrode may be formed on the work-function metal layers, and include a metal material such as Cu, W, Al, ruthenium (Ru), molybdenum (Mo), Co, and/or a combination thereof, not being limited thereto. The gate spacer 109 may be formed of silicon oxide or silicon nitride (e.g., SiO₂, SiN, SiBCN, SiCN, SiOC, SiOCN, etc.), not being limited thereto.

The gate structure 150 may be a common gate structure shared by the two transistors T1 and T2 to form a complementary metal oxide semiconductor (CMOS) device structure such as an inverter circuit, not being limited thereto. However, the disclosure is not limited thereto, an additional isolation may be formed to separate and isolate the gate structure 150 into two gate structures for the 1^{st} transistor T1 and the 2^{nd} transistor T2, respectively. A gate spacer 109 formed on side surfaces of an upper portion of the gate structure 150 may have been used to protect a dummy gate structure formed of polycrystalline silicon (p-Si) or amorphous silicon (a-Si) from various processes in manufacturing the 3D-stacked semiconductor device 10, and remain after the dummy gate structure is replaced by the gate structure 150 to prevent current leakage therefrom to other circuit elements.

Referring to FIGS. 1C and 1D, the 2^{nd} channel layers 120 may be formed to have a smaller width than the 1^{st} channel layers 110, in the D2 direction. Thus, the 2^{nd} source/drain regions 125 epitaxially grown from the 2^{nd} channel layers 120 may also be formed to have a smaller width than the 1^{st} source/drain regions 115 epitaxially grown from the 1^{st} channel layers 110, in the D2 direction. This width difference provides a space above a top surface of each of the 1^{st} source/drain regions 115 which is not vertically overlapped by the 2^{nd} source/drain region 125 so that a source/drain region contact structure may be formed through this space.

In the meantime, inner spacers 103 may be formed at each side of the inner gate structure 150A so that the gate structure 150 are isolated from the source/drain regions 115 and 125, thereby to prevent current leakage or a short circuit therebetween. The inner spacers 103 may be formed of a material such as silicon nitride (SiN, SiBCN, SiCN, SiOC, SiOCN, etc.), not being limited thereto, which may be different from the material(s) forming the gate spacer 109.

Each of the inner spacer 103 may be formed to have a half-oval or semicircle shape at each side of the inner gate structure 150A, and top and bottom surfaces of the inner spacer 103 may be at the same levels as those of the inner gate structure 150A, respectively, as shown in FIGS. 1B and 1E. Because of the this structural shape of the inner gate structure 150A, a distance between each of an upper-right edge E1 and a lower-right edge E2 of the inner gate structure 150A and the source/drain region 115 or 125 may not be sufficient, and thus, capacitance therebetween may increase because of their proximity to each other, thereby reducing AC performance of the 3D-stacked semiconductor device 10.

Moreover, as shown in FIG. 1F, when the inner gate structure 150A is formed by removing a sacrificial layer 120S formed of silicon germanium (SiGe) through dry or wet etching during a process of manufacturing the 3D-stacked semiconductor device 10, an etchant that removes the sacrificial layer 120S may penetrate through the upper-right edge E1 and the lower-right edge E2 to attack the 2^{nd} source/drain region 125 which is also formed of silicon germanium (SiGe) to damage the 2^{nd} source/drain region 125. Thus, loss of the 2^{nd} source/drain region 125 in the 2^{nd} transistor T2 of a p-type may occur, which should decrease a production yield.

The following embodiments address the foregoing issues that are caused by the inner spacers having a half-oval or semicircle shape.

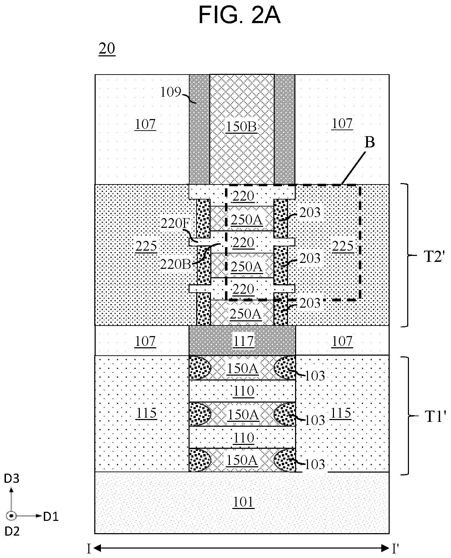

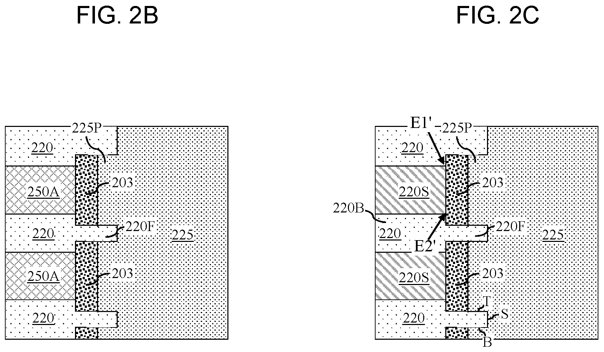

FIG. 2A illustrates a 3D-stacked semiconductor device formed of nanosheet transistors including thick inner spacers, according to one or more other embodiments. FIG. 2B is an enlarged view of a portion B shown in FIG. 2A, and FIG. 2C is a view of the portion B at an intermediate step of manufacturing the semiconductor device of FIG. 2A.

Referring to FIGS. 2A and 2B, a 3D-stacked semiconductor device 20 may include the same structural elements forming the 3D-stacked semiconductor device 10 shown in FIGS. 1A-1D, and thus, duplicate descriptions thereof may be omitted, and instead, different aspects of the 3D-stacked semiconductor device 20 may be described herein.

Similar to the 3D-stacked semiconductor device 10, the 3D-stacked semiconductor device 20 may include a 1^{st} transistor T1' of an n-type at a 1^{st} level and a 2^{nd} transistor T2' of a p-type at a 2^{nd} level above the 1^{st} level. However, while the 1^{st} transistor T1' of the 3D-stacked semiconductor device 20 may have the same structural shape as the 1^{st} transistor T1 of the 3D-stacked semiconductor device 10, the 2^{nd} transistor T2' of the 3D-stacked semiconductor device 20 may have a different structural shape than the 2^{nd} transistor T2 of the 3D-stacked semiconductor device 20.

For example, the 1^{st} transistor T1' of the 3D-stacked semiconductor device 20 may include a 1^{st} channel layers 110, an inner gate structure 150A (hereafter "1^{st} inner gate structure 150A"), 1^{st} source/drain regions 115, and inner spacers 103 (hereafter "1^{st} inner spacers 103") which have the same shapes or forms as those of the 1^{st} transistor T1 of the 3D-stacked semiconductor device 10. However, the 2^{nd} transistor T2' of the 3D-stacked semiconductor device 20 may include a 2^{nd} channel layers 220, an inner gate structure 250A (hereafter "2^{nd} inner gate structure 250A"), 2^{nd} source/drain regions 225, and inner spacers 203 (hereafter "2^{nd} inner spacers 203") which have different shapes or forms from those of the 2^{nd} transistor T2 of the 3D-stacked semiconductor device 10.

Unlike the 1^{st} inner spacers 103 having a half-oval or semicircle shape in the 1^{st} transistor T1', each of the 2^{nd} inner spacers 203 in the 2^{nd} transistor T2' may have a rectangular or a substantially rectangular shape of which two opposite side surfaces contact a side surface of the 2^{nd} inner gate structure 250A and a side surface of the 2^{nd} source/drain region 225 of the p-type, respectively. Further, unlike the 1^{st} inner spacers 103 each having the same thickness as that of each of the 1^{st} inner gate structure 150A, the 2^{nd} inner spacers 203 may each have a greater thickness than each of the 2^{nd} inner gate structure 250A, in the D3 direction. For example, a top surface of the 2^{nd} inner spacer 203 is at a higher level than a top surface of the 2^{nd} inner gate structure 250A, and a bottom surface of the 2^{nd} inner spacer 203 is at a lower level than a bottom surface of the 2^{nd} inner gate structure 250A. Accordingly, the 2^{nd} inner spacer 203 may be thicker than the 1^{st} inner spacer 103 in the D3 direction. Based on this structural shape, the proximity between the 2^{nd} inner gate structure 250A and the 2^{nd} source/drain regions 225 may be reduced to more effectively isolate the 2^{nd} inner gate structure 250A from the 2^{nd} source/drain regions 225 or vice versa in the 2^{nd} transistor T2' of a p-type, thereby increasing AC performance of the 3D-stacked semiconductor device 20.

Further, while each of the 1^{st} channel layers 110 may have a uniform thickness in the D3 direction along the D1 direction and plain side surfaces, each of the 2^{nd} channel layers 220 may have a thickness in the D3 direction varying along the D1 direction and may not have plain side surfaces. For example, each of the 2^{nd} channel layers 220 may have a body structure 220B surrounded by or interposed between two adjacent 2^{nd} inner gate structure 250A in the D3 direction and a fin structure 220F formed at each side of the body structure 220B. At least some of the fin structures 220F may be formed to penetrate into the 2^{nd} source/drain region 225 through a space between two adjacent inner spacers 203 in the D3 direction such that a portion T of a top surface, a portion B of a bottom surface, and an outer side surface S of the fin structure 220F are surrounded by and contact the 2^{nd} source/drain region 225. Thus, a contact surface between the 2^{nd} channel layers 220 and the 2^{nd} source/drain region 225 may increase to reduce contact resistance therebetween, thereby to increase DC performance of the 3D-stacked semiconductor device 20. Each of the fin structures 220F may have a smaller thickness than the body structure 220B in the D3 direction, and may have a same length as the 1^{st} inner spacer 103 in the D1 direction.

Moreover, as the 2^{nd} inner spacer 203 has a greater thickness than the 2^{nd} inner gate structure 250A and the 2^{nd} channel layer 220 has the fin structure 220F having a smaller thickness than the body structure 220B, the 2^{nd} source/drain region 225 may have a rectangular protrusion 225P having the same thickness in the D3 direction as that of the 2^{nd} inner spacer 203 and contacting a side surface of the 2^{nd} inner spacer 203. In addition, due to the formation of the rectangular-shaped 2^{nd} inner spacer 203 and the protrusion 225P of the 2^{nd} source/drain region 225 of the p-type, a length of the 2^{nd} source/drain region 225 may be greater than that of the 1^{st} source/drain region 115 by a length of the protrusion 225P, and further, a length of the 2^{nd} inner gate structure 250A connecting the 2^{nd} source/drain regions 225 may be smaller than that of the 1^{st} inner gate structure 150A connecting the 1^{st} source/drain regions 115 by a length of the protrusion 225P, in the D1 direction. Further, an outer side surface of the 2^{nd} inner spacer 203 contacting the protrusion 225P of the 2^{nd} source/drain region 225 is not vertically aligned with or coplanar with an outer side surface of the 2^{nd} channel layer 220, that is, the outer side surface S of the fin structure 220F of the 2^{nd} channel layer 220.

In the meantime, as shown in FIG. 2C, when the 2^{nd} inner gate structure 250A is formed by removing a sacrificial layer 220S formed of silicon germanium (SiGe) through wet etching, the rectangular-shaped thick 2^{nd} inner spacer 203 may prevent an wet etchant that removes the sacrificial layer 220S from penetrating through an upper-right edge E1' and a lower-right edge E2' to attack the 2^{nd} source/drain region 225 which is also formed of silicon germanium (SiGe) to damage the 2^{nd} source/drain region 225. Thus, loss of the 2^{nd} source/drain region 225 of the 2^{nd} transistor T2 of a p-type may be prevented, which should increase a production yield. However, at least because the same wet etchant may not attack silicon (Si) forming the 1^{st} source/drain regions 115 of the 1^{st} transistor T1' of an n-type due to the etch selectivity between silicon (Si) and silicon germanium (SiGe), the 1^{st} inner spacers 103 may not be formed as the 2^{nd} inner spacers 203.

It is to be understood here that the 2^{nd} inner gate structure 250A may include the same material forming the 1^{st} inner gate structure 150A and the outer gate structure 150B when the gate structure of the 3D-stacked semiconductor device 20 is a common gate structure shared by the two transistors T1' and T2' like the gate structure 150 of the 3D-stacked semiconductor device 10. Also, like in the 3D-stacked semiconductor device 10, an additional isolation may be formed to separate and isolate the gate structure of the 3D-stacked semiconductor device 20 into two gate structures for the 1^{st} transistor T1' and the 2^{nd} transistor T2', respectively, in which case the outer gate structure 150B and the 2^{nd} inner gate structure 250A may form a gate structure of the 2^{nd} transistor T2', and the 1^{st} inner gate structure 150A may form a gate structure of the 1^{st} transistor T1'.

Herebelow, a method of manufacturing a 3D-stacked semiconductor device corresponding to the 3D-stacked semiconductor device 20 of FIG. 2A may be provided.

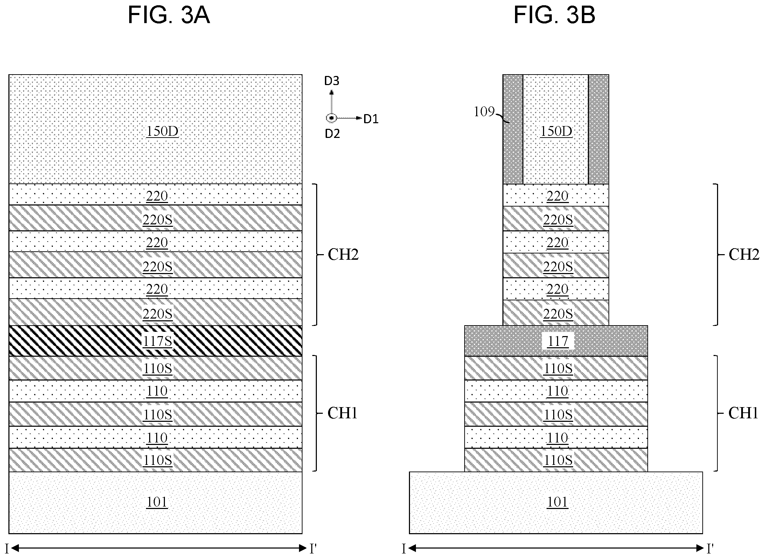

FIGS. 3A through 3L illustrate cross-section views of intermediate 3D-stacked semiconductor devices after respective steps of manufacturing a 3D-stacked semiconductor device formed of nanosheet transistors including thick inner spacers, according to one or more other embodiments. The 3D-stacked semiconductor device manufactured through the respective steps herein may be or correspond to the 3D-stacked semiconductor device 20 shown in FIG. 2A, and thus, the cross-section views of the intermediate 3D-stacked semiconductor device may correspond to that shown in FIG. 2A. Further, duplicate descriptions about the same structural elements described above in reference to FIG. 2A may be omitted and the same reference characters or numerals may be used herebelow for brevity and consistency purposes.

Referring to FIG. 3A, an initial semiconductor device structure may be formed by epitaxially growing a plurality of nanosheet layers one by one from the substrate 101 to form a 1^{st} channel stack CH1, a sacrificial isolation stack 117S and a 2^{nd} channel stack CH2 in this order on the substrate 101. Further, a dummy gate structure 150D may be formed on the semiconductor device structure.

The 1^{st} channel stack CH1 may include 1^{st} sacrificial layers 110S and 1^{st} channel layers 110 vertically stacked in an alternating manner on the substrate 101. In the 1^{st} channel stack CH1, a 1^{st} channel layer 110 may be interposed between two adjacent 1^{st} sacrificial layers 110S. On the 1^{st} channel stack CH1 may be formed the sacrificial isolation stack 117S. On the sacrificial isolation stack 117S may be formed the 2^{nd} channel stack CH2 which may include 2^{nd} sacrificial layers 120S and 2^{nd} channel layers 120 vertically stacked in an alternating manner on the sacrificial isolation stack 117S. In the 2^{nd} channel stack CH2, a 2^{nd} channel layer 120 may be interposed between two adjacent 2^{nd} sacrificial layer 120S except the uppermost 2^{nd} channel layer 120. The sacrificial isolation stack 117S may be interposed between the uppermost 1^{st} sacrificial layer 110S and the lowermost 2^{nd} sacrificial layer 220S.

In the 1^{st} channel stack CH1, the 1^{st} sacrificial layers 110S may be formed of silicon germanium (SiGe) and the 1^{st} channel layers 110 may be formed of silicon (Si). Similarly, in the 2^{nd} channel stack CH2, the 2^{nd} sacrificial layers 120S may be formed of silicon germanium (SiGe) and the 2^{nd} channel layers 120 may be formed of silicon (Si). The sacrificial isolation stack 117S may also be formed of silicon germanium (SiGe). However, germanium (Ge) concentration in the sacrificial isolation stack 117S may be higher than in the 1^{st} sacrificial layers 110S as will be described later. For example, the sacrificial isolation stack 117S may have Ge concentration 50-60% while the sacrificial layers 110S and 220S may have Ge concentration 20-30%. However, the disclosure is not limited to these specific percentages as long as the sacrificial isolation stack 117S has a higher Ge concentration than the sacrificial layers 1105 and 220S to allow sufficient etch selectivity against the sacrificial layers 110S and 220S as well as the channel layers 110 and 120.

Here, the sacrificial isolation stack 117S and the sacrificial layers 110S and 120S are termed as such because these structural elements will be removed and replaced by other layers or structures in later steps of manufacturing the 3D-stacked semiconductor device.

The dummy gate structure 150D may be formed by depositing polysilicon (p-Si) or amorphous silicon (a-Si) on the semiconductor device structure through, for example, physical vapor deposition (PVD), chemical vapor deposition (CVD), plasma enhanced chemical vapor deposition (PECVD), or a combination thereof, followed by planarization such as chemical-mechanical polishing (CMP), not being limited thereto. A purpose of forming the dummy gate structure 150D is to protect the channel stacks CH1 and CH2 from various operations such as deposition and etching to form surrounding structures in subsequent processes of manufacturing a 3D-stacked semiconductor device. The dummy gate structure 150D may also serve to define dimensions of the channel layers 110 and 120 for the 3D-stacked semiconductor device.

Referring to FIG. 3B, the sacrificial isolation stack 117S may be removed and replaced by a middle isolation structure 117, and the channel stacks CH1 and CH2 with the dummy gate structure 150D thereon may be patterned such that the 2^{nd} channel structure CH2 has a smaller length in the D1 direction and a shorter width in the D2 direction. Further, a gate spacer 109 may be formed on side surfaces of the dummy gate structure 150D.

The sacrificial isolation stack 117S may be removed through, for example, selective patterning such as dry etching or wet etching using hydrofluoric acid (HF), which etches the sacrificial isolation stack 117S formed of silicon germanium (SiGe) with a high germanium (Ge) concentration of 50-60% against the sacrificial layers 110S and 220S formed of silicon germanium (SiGe) with a low Ge concentration of 20-30% and the channel layers 110 and 120 formed of silicon (Si). Subsequently, in a space provided by the removal of the sacrificial isolation stack 117S may be filled in with a dielectric material such as silicon nitride (e.g., SiN, SiBCN, SiCN, SiOCN, etc.), not being limited thereto, to form a middle isolation structure 117.

After the formation of the middle isolation structure 117, the channel stacks CH1 and CH2 may be patterned both in the D1 direction and the D2 direction through, for example, photolithography, masking and etching such as dry etching or wet etching. The D1-direction patterning may be performed to form inner spacers and source/drain regions in later steps, and the D2-direction patterning may form the 2^{nd} channel stack CH2 to have a shorter channel width than the 1^{st} channel stack CH1 so that source/drain regions formed based on the 2^{nd} channel stack CH2 in a later step can have a shorter width in the D2 direction, as described above in references to FIGS. 1A-1D. The D1-direction patterning may also be performed such that portions of a top surface of the sacrificial isolation stack 117S may be exposed at both sides of the 2^{nd} channel stack CH2 so that the top surface of the sacrificial isolation stack 117S may protect the 1^{st} channel stack CH1 from an operation of forming inner spacers on the 2^{nd} channel stack CH2 in a next step.

The gate spacer 109 may be formed on side surfaces of the dummy gate structure 150D by depositing silicon oxide or silicon nitride (e.g., SiO₂, SiN, SiBCN, SiCN, SiOC, SiOCN, etc.) through, for example, atomic layer deposition (ALD), plasma-enhanced ALD (PEALD), PVD, CVD, PECVD, or a combination thereof, followed by dry etching, not being limited thereto. The gate spacer 109 may isolate or protect the dummy gate structure 150D (and a gate structures which will replace the dummy gate structure 150D in a later step) from being oxidized in subsequent processes of manufacturing the 3D-stacked semiconductor device

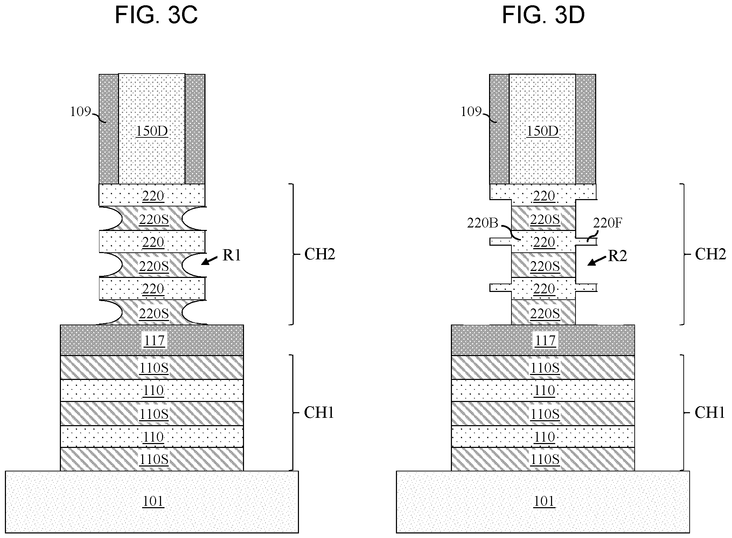

Referring to FIG. 3C, a 1^{st} selective patterning operation may be performed on side surfaces of the 2^{nd} sacrificial layers 220S formed of silicon germanium (SiGe) to pull back a portion of each of these layers based on the dummy gate structure 150D and the gate spacer 109 as masking structure, thereby forming a 1^{st} recess R1 at each side surface of each of the 2^{nd} sacrificial layers 220S.

For the 1^{st} selective patterning operation in this step, dry etching or wet etching may be performed using an etchant, for example, chlorine/oxygen (Cl₂/O₂), a mixture of hydrofluoric acid (HF) and ammonium fluoride (NH₄F), not being limited thereto, which has a high etch selectivity of silicon germanium (SiGe) forming the 2^{nd} sacrificial layers 220S against silicon (Si) forming the 2^{nd} channel layers 220 and silicon nitride forming the middle isolation structure 117.

The 1^{st} recess R1 formed by the 1^{st} selective patterning operation in this step may have a half-oval or semicircle shape, and a height of the 1^{st} recess R1 may be the same as a thickness of the 2^{nd} sacrificial layer 220S, in the D3 direction.

Referring to FIG. 3D, a 2^{nd} selective patterning operation may be performed on the 1^{st} recess R1 obtained in the previous step (FIG. 3C) to enlarge the 1^{st} recess R1 to form a 2^{nd} recess R2 at each side surface of each of the 2^{nd} sacrificial layers 220S.

For the 2^{nd} selective patterning operation in this step, dry etching or wet etching may be performed using an etchant, for example, sulfur hexafluoride (SF), tetramethylammonium hydroxide (TMAH), or potassium hydroxide (KOH), not being limited thereto, which has a high etch selectivity of silicon (Si) forming the 2^{nd} channel layers 220.

When the 2^{nd} selective patterning is directed to the 1^{st} recess R1, the 1^{st} recess R1 may be enlarged at least in the D3 direction by etching portions of the 2^{nd} sacrificial layer 220S above and below the 1^{st} recess R1 and portions of the 2^{nd} channel layers 220 close to the 1^{st} recess R1, thereby forming a rectangular or substantially rectangular shape. The 2^{nd} recess R2 may be formed such that a height thereof may be greater than a thickness of the 2^{nd} sacrificial layer 220S in the D3 direction. For example, a top edge or ceiling of the 2^{nd} recess R2 may be at a higher level than a top surface of the 2^{nd} sacrificial layer 220S exposed through the 2^{nd} recess R2, and a bottom edge or bottom of the 2^{nd} recess R2 may be at a lower level than a bottom surface of this 2^{nd} sacrificial layer 220S.

Further, as the 2^{nd} recess R2 is formed in the above manner, the 2^{nd} channel layers 220 may each have a body structure 220B and a fin structure 220F protruding from each lateral side of the body structure 220B in the D1 direction. The body structure 220B and the fin structure 220F may have different thicknesses in the D3 direction. The thickness of the fin structure 220F may become smaller than that of the body part 220B in each of the 2^{nd} channel layers 220. Thus, the 2^{nd} recess R2 may be defined between two vertically adjacent fin structures 220F in the D3 direction.

However, the disclosure is not limited thereto, and one or more additional etching operations may be performed to enlarge the 1^{st} recess R1 to have the rectangular or substantially rectangular shape, thereby forming the 2^{nd} recess R2.

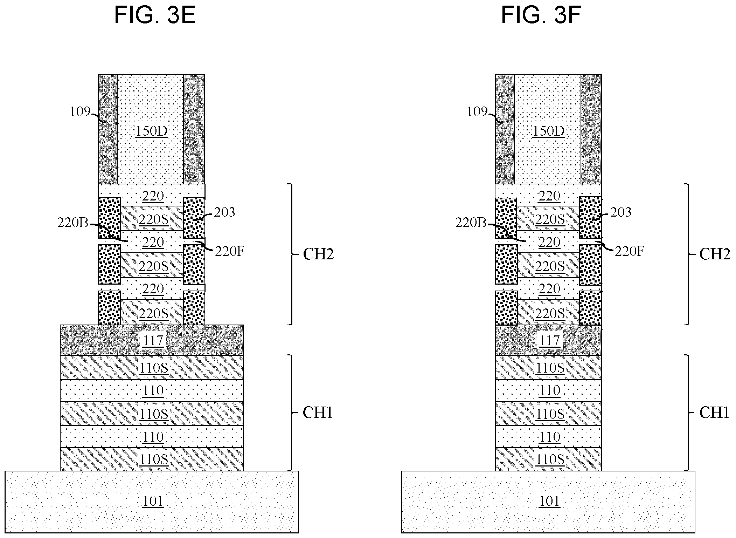

Referring to FIG. 3E, the 2^{nd} recess R2 obtained in the previous step (FIG. 3E) may be filled in with a dielectric material such as silicon nitride (e.g., SiN, SiBCN, SiCN, SiOC, SiOCN, etc.), not being limited thereto) through, for example, ALD, PVD, PEALD, CVD, PECVD, or a combination thereof, not being limited thereto followed by side planarization.

Thus, a 2^{nd} inner spacer 203 may also be formed to have the same rectangular or substantially rectangular shape as the 2^{nd} recess R2 at each side surface of each of the 2^{nd} sacrificial layers 220S, and side surfaces of the 2^{nd} inner spacers 203 may be vertically aligned or coplanar with the side surfaces of the 2^{nd} channel layers 220 and the gate spacer 109. Further, each of the 2^{nd} inner spacers 203 filling the 2^{nd} recess R2 may be formed to have a greater thickness than the 2^{nd} sacrificial layer 220S. For example, a top surface of the 2^{nd} inner spacer 203 may be at a higher level than a top surface of the 2^{nd} sacrificial layer 220S at a lateral side of the 2^{nd} inner spacer 203, and a bottom surface of the 2^{nd} inner spacer 203 may be at a lower level than a bottom surface of this 2^{nd} sacrificial layer 220S.

Referring to FIG. 3F, the 1^{st} channel stack CH1 and the middle isolation structure 117 thereon may be patterned based on the dummy gate structure 150D and the gate spacer 109 as masking structure.

The patterning operation in this step may be performed through, for example, dry etching or wet etching such that side surfaces of the 1^{st} channel layers 110, the 1^{st} sacrificial layers 110S and the middle isolation structure 117 may be vertically aligned with or coplanar with the side surfaces of the 2^{nd} inner spacers 203, the 2^{nd} channel layers 220 and the gate spacer 109.

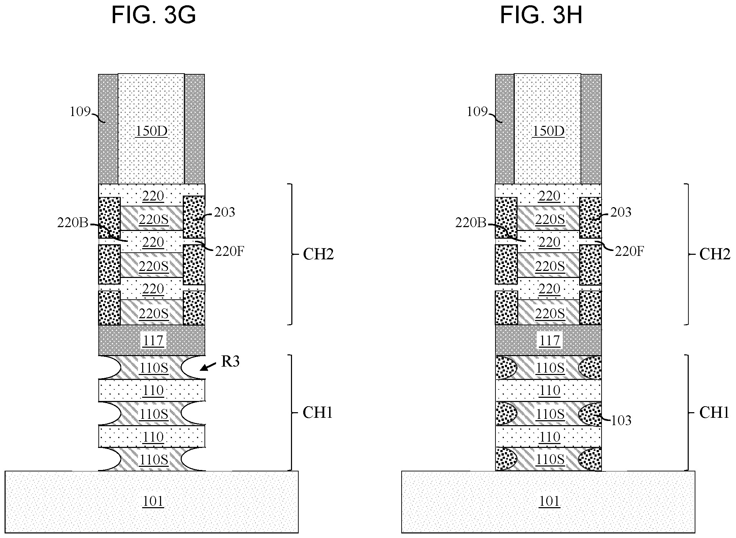

Referring to FIG. 3G, a 3^{rd} selective patterning operation may be performed on side surfaces of the 1^{st} sacrificial layers 110S formed of silicon germanium (SiGe) to pull back a portion of each of these layers based on the 2^{nd} channel structure CH2 as well as the dummy gate structure 150D and the gate spacer 109 as masking structure.

For the 3^{rd} selective patterning operation in this step, dry etching or wet etching may be performed using an etchant, for example, chlorine/oxygen (Cl₂/O₂), a mixture of hydrofluoric acid (HF) and ammonium fluoride (NH₄F), not being limited thereto, which has a high etch selectivity of silicon germanium (SiGe) forming the 1^{st} sacrificial layers 110S against silicon (Si) forming the channel layers 110 and 220, and silicon nitride forming the inner spacers 203 and the middle isolation structure 117.

After the 3^{rd} selective patterning operation in this step, a 3^{rd} recess R3 of a half-oval or semicircle shape, which is the same as or similar to the 1^{st} recess R1 obtained in the previous step (FIG. 3C), may be formed at each side of the 1^{st} sacrificial layer 110S because the 3^{rd} selective patterning may be performed in the same manner as the 1^{st} selective patterning on the same materials. For example, a length in the D1 direction and a height in the D3 direction of the 3^{rd} recess R3 may be the same as those of the 1^{st} recess R1.

Referring to FIG. 3H, the 3^{rd} recesses R3 may be filled in with a dielectric material such as silicon nitride (e.g., SiN, SiBCN, SiCN, SiOC, SiOCN, etc.), not being limited thereto) through, for example, ALD, PVD, PEALD, CVD, PECVD, or a combination thereof, not being limited thereto followed by side planarization. Thus, a 1^{st} inner spacer 103 may be formed to have the same half-oval or semicircle shape as the 3^{rd} recess R3 at each side surface of each of the 1^{st} sacrificial layers 110S, and side surfaces of the 1^{st} inner spacers 103 may be vertically aligned or coplanar with the side surfaces of at least the 1^{st} channel layers 110.

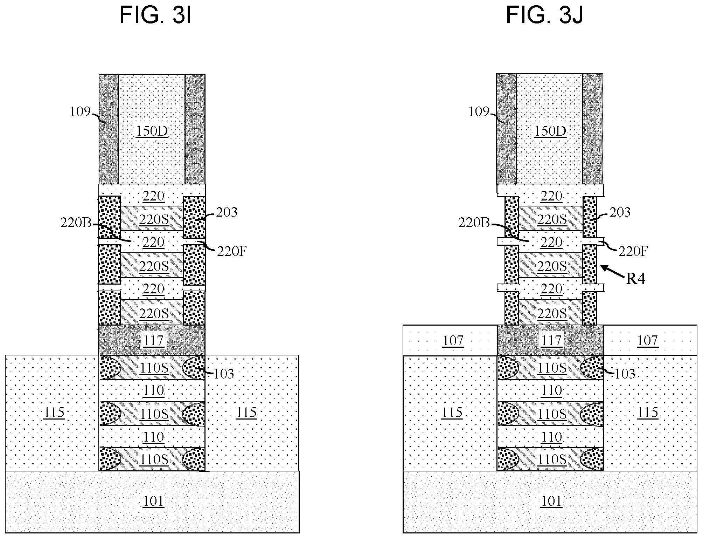

Referring to FIG. 3I, 1^{st} source/drain regions 115 may be formed based on the 1^{st} channel layers 110 while the 1^{st} sacrificial layers 110S are covered by the 1^{st} inner spacers 103, respectively.

The 1^{st} source/drain regions 115 may be epitaxially grown from the 1^{st} channel layers 110 through, for example, molecular beam epitaxy (MBE), vapor-phase epitaxy (VPE), etc., not being limited thereto. The 1^{st} source/drain regions 135 may be formed silicon (Si), and may be doped in-situ with impurities such as phosphorus (P), arsenic (As), antimony (Sb), etc., and thus, a 1^{st} transistor T1' to be formed based on the 1^{st} channel layers 110 and the 1^{st} source/drain regions 115 at the 1^{st} level will be of an n-type.

Referring to FIG. 3J, an isolation structure 107 may be formed on the 1^{st} source/drain regions 115, and each of the 2^{nd} inner spacers 203 may be partially patterned at side surfaces thereof to form a 4^{th} recess R4.

The partial patterning in this step may be performed through, for example, dry etching or wet etching using an etchant such as sulfur hexafluoride (SF₆) or hot phosphoric acid (H₃PO₄), not being limited thereto. The partial patterning may be performed such that a side surface of each of the 2^{nd} inner spacers 203 is uniformly etched along the D3 direction by a predetermined distance in the D1 direction to form the 4^{th} recess R4 also having a rectangular or substantially rectangular shape. Thus, a length of the 2^{nd} inner spacer 203 and a length the 4^{th} recess R4 may be reduced as much as the predetermined distance. Still, however, each of the 2^{nd} inner spacers 203 may have a greater thickness than the 2^{nd} sacrificial layer 220S. For example, the top surface of the 2^{nd} inner spacer 203 may be maintained at a higher level than the top surface of the 2^{nd} sacrificial layer 220S at a lateral side of the 2^{nd} inner spacer 203, and the bottom surface of the 2^{nd} inner spacer 203 may be maintained at a lower level than the bottom surface of this 2^{nd} sacrificial layer 220S.

Thus, the 2^{nd} inner spacer 203 may take a form of partially filling the 2^{nd} recess R2 obtained in the previous step (FIG. 3D) such that the length of the 2^{nd} inner spacer 203 is smaller than a length of the 2^{nd} recess R2 in the D1 direction while the top surface and the bottom surface of the 2^{nd} inner spacer 203 contact the top edge and the bottom edge of the 2^{nd} recess R2, respectively.

Due to the formation of the 4^{th} recesses R4 in the above manner, the fin structure 220F of each of the 2^{nd} channel layers 220 may be protruded through two vertically adjacent 2^{nd} inner spacers 203 to expose a portion T of a top surface, a portion B of a bottom surface and a side surface S of the fin structure 220F as shown in FIG. 2C. Thus, the 4^{th} recess R4 may be defined between protrusions of two vertically adjacent fin structures 220F in the D3 direction.

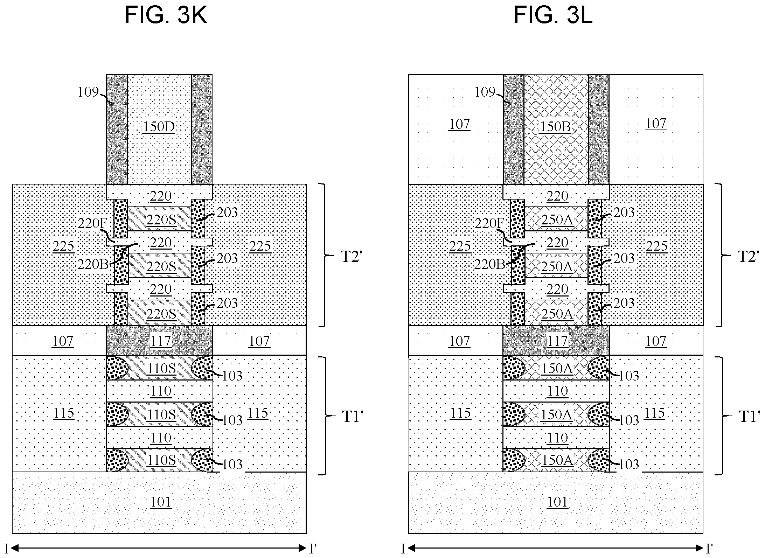

Referring to FIG. 3K, 2^{nd} source/drain regions 225 may be formed based on the 2^{nd} channel layers 110 while the 2^{nd} sacrificial layers 220S are covered by the 2^{nd} inner spacers 203.

The 2^{nd} source/drain regions 225 may be epitaxially grown from the 2^{nd} channel layers 220 also through, for example, molecular beam epitaxy (MBE), vapor-phase epitaxy (VPE), etc., not being limited thereto. Here, each of the 2^{nd} source/drain regions 225 may be epitaxially grown from the portions T, B and S of the fin structure 220F exposed to the outside in the previous step (FIG. 3J), and thus, the 2^{nd} source/drain region 225 may take a form of surrounding these portions of the fin structure 220F. Accordingly, a contact surface of each of the 2^{nd} channel layers 220 with the 2^{nd} source/drain region 225 may increase to enhance DC performance of a 3D-stacked semiconductor device to be completed in a later step.

Further, due to the fin structure 220F of the 2^{nd} channel layer 220, the 2^{nd} source/drain region 225 may also have a protrusion form contacting a side surface of the 2^{nd} inner spacer 203, and thus, a length of the 2^{nd} source/drain region 225 may be greater than a length of the 1^{st} source/drain region 115, in the D1 direction.

The 2^{nd} source/drain regions 225 may be formed of silicon germanium (SiGe), and may be doped in-situ with impurities such as phosphorus (P), arsenic (As), antimony (Sb), etc., and thus, a 2^{nd} transistor T2' to be formed based on the 2^{nd} channel layers 220 and the 2^{nd} source/drain regions 225 at the 2^{nd} level will be of a p-type.

Referring to FIG. 3L, the dummy gate structure 150D and the sacrificial layers 110S and 120S may be removed through, for example, dry etching, wet etching, or a combination thereof, not being limited thereto, using an etchant, for example, as a mixture of nitric acid (HNO₃) and hydrofluoric acid (HF), not being limited thereto, to release the channel layers 110 and 220 forming the channel structures for the transistors T 1' and T2' of the 3D-stacked semiconductor device, respectively.

Subsequently, spaces formed by the removal of the dummy gate structure 150D and the sacrificial layers 110S and 220S may be filled in with a replacement gate structure (RMG) including a 1^{st} inner gate structure 150A, a 2^{nd} inner gate structure 250A and an outer gate structure 150B. Thus, as the 2^{nd} inner gate structure 250A may have the same structural shape as the 2^{nd} sacrificial layer 220S with respect to the 2^{nd} inner spacer 203 and the 2^{nd} channel layer 220 adjacent thereto. For example, each of the 2^{nd} inner spacers 203 may have a greater thickness than the 2^{nd} inner gate structure 250A in the D3 direction, and thus, the top surface of the 2^{nd} inner spacer 203 may be at a higher level than a top surface of the 2^{nd} inner gate structure 250A at a lateral side of the 2^{nd} inner spacer 203, and the bottom surface of the 2^{nd} inner spacer 203 may be at a lower level than a bottom surface of this 2^{nd} inner gate structure 250A.

In this step, due to the 2^{nd} inner spacers 203 having the above-described structural shape, the etchant removing silicon germanium (SiGe) of the 2^{nd} sacrificial layers 220S may be prevented from attacking the same silicon germanium (SiGe) forming the 2^{nd} source/drain regions 225 of the 2^{nd} transistor T2 of a p-type. Further, a distance between the 2^{nd} inner gate structure 250A and the 2^{nd} source/drain region 205 is extended by the 2^{nd} inner spacer 203, AC performance of the 3D-stacked semiconductor device to be completed in a later step may be enhanced. In the meantime, the etchant removing the 1^{st} sacrificial layers 110S as well as the 2^{nd} sacrificial layers 220S may not attack silicon (Si) forming the 1^{st} source/drain regions 115. At least for this reason, it may not have been necessary to form the 1^{st} inner spacers 103 as the 2^{nd} inner spacers 202.

Further in this step, the isolation structure 107 formed between the 1^{st} source/drain regions 115 and the 2^{nd} source/drain regions 225 may be expanded above the 2^{nd} source/drain regions 115 through, for example, CVD, PVD, PECVD, or a combination thereof, not being limited thereto, followed by CMP, thereby forming a 3D-stacked semiconductor device which is the same as or correspond to the 3D-stacked semiconductor device 20 shown in FIG. 2A.

Herebelow, a method of manufacturing a 3D-stacked semiconductor device corresponding to the 3D-stacked semiconductor device 20 is provided.

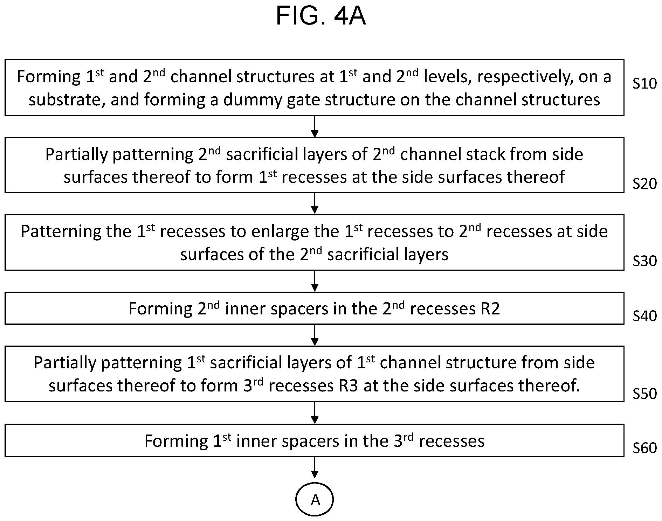

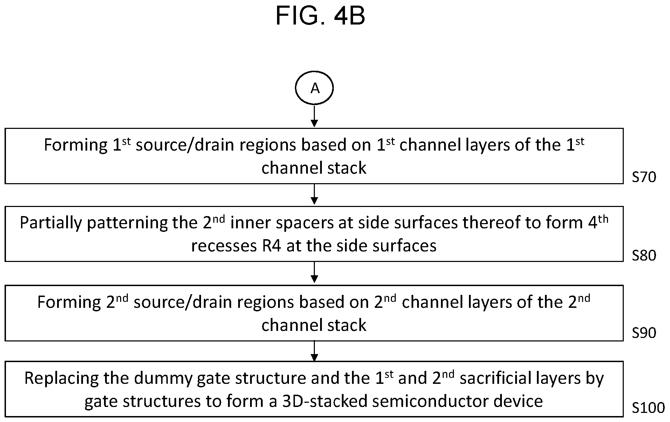

FIGS. 4A and 4B illustrate a flowchart of a method of manufacturing a 3D-stacked semiconductor device formed of nanosheet transistors including thick inner spacers in reference to FIGS. 3A-3L, according to one or more other embodiments.

The 3D-stacked semiconductor device manufactured according to the flowchart of FIG. 4 may be the same as or correspond to the 3D-stacked semiconductor device 20 shown in FIG. 2A, and processes performed for each step of manufacturing the 3D-stacked semiconductor device may be the same as or similar to those described above in reference to FIGS. 3A-3L. Thus, duplicate descriptions may be omitted herein, and the same reference characters or numerals may be used herebelow for brevity and consistency purposes.

In step S10, a 1^{st} channel structure CH1 for a 1^{st} transistor T1' at a 1^{st} level and a 2^{nd} channel structure CH2 for a 2^{nd} transistor T2' at a 2^{nd} level above the 1^{st} level may be formed on a substrate 101, and a dummy gate structure 150D may be formed to surround the channel structures CH1 and CH2.

The 1^{st} transistor T1' may be a nanosheet transistor including a plurality of 1^{st} sacrificial layers 110S and 1^{st} channel layers 110 alternatingly stacked on the substrate 101, and the 2^{nd} transistor T2' may also be a nanosheet transistor including a plurality of 2^{nd} sacrificial layers 220S and 2^{nd} channel layers 220 alternatingly stacked above the 1^{st} transistor T1'.

In step S20, the 2^{nd} sacrificial layers 220S may be partially patterned from side surfaces thereof to form 1^{st} recesses R1 at the side surfaces thereof, respectively. Here, a height of each of the 1^{st} recess R1 may be the same or substantially the same as a thickness of a 2^{nd} sacrificial layer 220S in the D3 direction. The 1^{st} recesses R1 may each have a half-oval or semicircle shape.

In step S30, the 1^{st} recesses R1 may be further patterned to enlarge the 1^{st} recesses R1 to 2^{nd} recesses R2 at side surfaces of the 2^{nd} sacrificial layers 220S, respectively, by which a height of each of the 2^{nd} recesses R2 becomes greater than the thickness of a 2^{nd} sacrificial layer 220S in the D3 direction. The 2^{nd} recesses R2 may each have a rectangular or substantially rectangular shape, not being limited thereto.

Due to the formation of the 2^{nd} recess R2 at each side surface of each of the 2^{nd} sacrificial layers 220S, the 2^{nd} channel layers 220 may each have a body structure 220B and a fin structure 220F protruding from each lateral side of the body structure 220B.

In step S40, 2^{nd} inner spacers 203 may be formed in the 2^{nd} recesses R2, respectively, to have the same rectangular or substantially rectangular shape as the 2^{nd} recesses R2 and contact side surfaces of the 2^{nd} channel layers 220.

Here, as the 2^{nd} recesses R2 each may have been enlarged by patterning the 1^{st} recesses R1, each of the 2^{nd} inner spacers 203 filled therein may also have a greater thickness than the thickness of a 2^{nd} sacrificial layer 220S in the D3 direction.

In step S50, the 1^{st} sacrificial layers 110S may be partially patterned from side surfaces thereof to form 3^{rd} recesses R3 at the side surfaces thereof. Here, a height of each of the 3^{rd} recesses R3 may be the same or substantially the same as a thickness of a 1^{st} sacrificial layer 110S in the D3 direction. Like the 1^{st} recess R1, the 3^{rd} recess may have a half-oval or semicircle shape.

In step S60, 1^{st} inner spacers 103 may be formed in the 3^{rd} recesses, respectively, to have the same half-oval or semicircle shape, and contact side surfaces of the 1^{st} sacrificial layers 110S, respectively.

In step S70, 1^{st} source/drain regions 115 may be formed based on the 1^{st} channel layers 110. The 1^{st} source/drain regions 115 may be isolated from the 1^{st} sacrificial layers 110S by the 1^{st} inner spacers 103, respectively.

In step S80, the 2^{nd} inner spacers 203 may be partially patterned at side surfaces thereof to form 4^{th} recesses R4 at the side surfaces thereof, respectively, to expose a portion of the fin structure 220F protruded from a lateral side of the body part 220B of each of the 2^{nd} channel layers 220.

Here, the 4^{th} recesses R4 may each also have a rectangular or substantially rectangular shape although a size thereof is reduced by the partial patterning in this step.

In step S90, 2^{nd} source/drain regions 225 may be formed based on the exposed portions of the fin structures 220F of the 2^{nd} channel layers 220.

At this time, the 2^{nd} source/drain regions 225 may also fill out the 4^{th} recesses R4, and thus, the 2^{nd} source/drain regions 225 may also have a protrusion form toward the 2^{nd} inner spacers 203, respectively. Accordingly, a length of a 2^{nd} source/drain region 225 may be greater than that of a 1^{st} source/drain region 115 formed therebelow, in the D1 direction.

In step S100, the dummy gate structure 150D and the sacrificial layers 110S and 220S may be replaced by gate structures 150A, 150B and 250A, respectively, to form a 3D-stacked semiconductor device.

The gate structure 150A replacing the 1^{st} sacrificial layers 110S may surround the 1^{st} channel layers 110, and the gate structure 250A replacing the 2^{nd} sacrificial layers 220S may surround the 2^{nd} channel layers 220. The gate structure 150B may be formed above the uppermost 2^{nd} channel layer 220. The gate structures 150A may be a gate structure of the 1^{st} transistor T1' and the gate structures 250A and 150B may be a gate structure of the 2^{nd} gate structure T2'

When the two transistors T1' and T2' of the 3D-stacked semiconductor device are to share a gate structure, the gate structures 150A, 150B and 250A may be connected to each other, and, where the two transistors T1' and T2' of the 3D-stacked semiconductor device are not to share a gate structure, the gate structures 150A may be isolated from the gate structures 150B and 250A connected to each other.

Through the above method and steps, a 3D-stacked semiconductor device which may be or correspond to the 3D-stacked semiconductor device 20 of FIG. 2A may be manufactured to have thick inner spacers for a p-type nanosheet transistor at a 2^{nd} level. As described earlier, these thick inner spacers may be able to prevent an etchant to remove sacrificial layers of a channel structure from attaching source/drain regions during the process of manufacturing the 3D-stacked semiconductor device, and may also reduce a short-circuit risk between a gate structure and source/drain regions after the 3D-stacked semiconductor device is manufactures. Further, these thick inner spacers may enhance AC performance of the 3D-stacked semiconductor device. Moreover, the channel layers formed based on the thick inner spacers may have a fin structure enabling an increase contact surface on a source/drain region may contribute to enhancing DC performance of the 3D-stacked semiconductor device.

The above embodiments describe that a thick inner spacer may take a rectangular or substantially rectangular shape. However, the disclosure is not limited thereto. According to one or more other embodiments, the thicker inner spacer may have a different shape or form (e.g., a vertically elongated oval shape) subject to partial patterning of a sacrificial layer as long as a thickness of the inner spacer is greater than that of the gate structure at a side thereof, and a top surface of the inner spacer is at a higher level than a top surface of the gate structure and a bottom surface of the inner spacer is at a lower level than a bottom surface of the gate structure in the D3 direction.

The above embodiments also describe that a thick inner spacer may be formed to isolate only a p-type source/drain region of a nanosheet transistor at a 2^{nd} level of a 3D-stacked semiconductor device from a gate structure of the same nanosheet transistor. However, the disclosure is not limited thereto, and the thick inner spacer may also be formed to isolate an n-type source/drain region of a nanosheet transistor at a 1^{st} level of the 3D-stacked semiconductor device from a gate structure of the same nanosheet transistor, according to one or more other embodiments. Further, the thick inner spacer may be formed to isolate a p-type or n-type source/drain region of a single-stack or single-level nanosheet transistor from a gate structure of the same nanosheet transistor.

The above embodiments also describe that a source/drain region isolated by a gate structure by a thick inner spacer is a source/drain region of a nanosheet transistor at a 2^{nd} level in a 3D-stacked semiconductor device. However, the disclosure is not limited thereto, and this p-type source/drain region may be formed at a 1^{st} level in the 3D-stacked semiconductor device, according to one or more other embodiments.

Moreover, the above embodiments (in reference to, e.g., FIG. 3B) describe that a 3D-stacked semiconductor device including thick inner spacers have a shorter channel width and a shorter source/drain region width in a nanosheet transistor at a 2^{nd} level than in a nanosheet transistor at a 1^{st} level. However, the inner spacer may be formed in a 3D-stacked semiconductor device having the same channel width and source/drain region width across the 1^{st} level and the 2^{nd} level, according to one or more other embodiments.

The thick inner spacers described in the above embodiments may also be formed in a forksheet transistor structure according to one or more embodiments. The forksheet transistor may take a form of a combination of two nanosheet transistors with an isolation wall therebetween as an insulation backbone. Nanosheet channel layers of each nanosheet transistor in the forksheet transistor may be formed at each side of the isolation wall and pass through a gate structure of the nanosheet transistor at each side of the isolation wall.

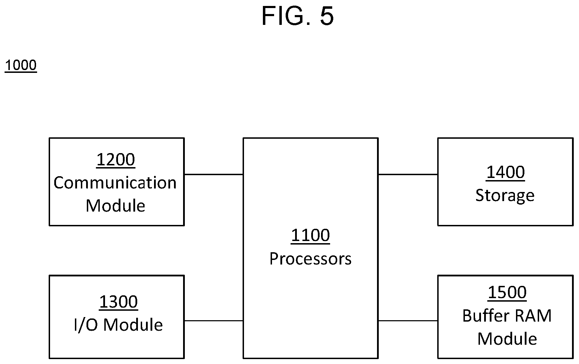

FIG. 5 is a schematic block diagram illustrating an electronic device including a semiconductor device in which improved inner spacers are formed, according to one or more embodiments. This semiconductor device may be or correspond to the 3D-stacked semiconductor devices 20 shown in FIGS. 2A-2C or only the 2^{nd} transistor T2' of the 3D-stacked semiconductor device 20.

Referring to FIG. 5, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 5, the electronic device 1000 may further include at least one sensor such as an image sensor.

At least one component in the electronic device 1000 may be formed based on a semiconductor device in which improved inner spacers are formed as described in reference to FIGS. 2A-2C.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a plurality of 1^{st} channel layers arranged in a 1^{st} direction;
a 1^{st} source/drain region on the plurality of 1^{st} channel layers;
a 1^{st} gate structure comprising a 1^{st} inner gate structure between two adjacent 1^{st} channel layers among the plurality of 1^{st} channel layers; and
a 1^{st} inner spacer between the 1^{st} inner gate structure and the 1^{st} source/drain region,
wherein the 1^{st} inner spacer has a greater thickness than the 1^{st} inner gate structure in the 1^{st} direction.

2. The semiconductor device of claim 1, wherein the 1^{st} source/drain region comprises a protrusion toward the 1^{st} inner gate structure,
wherein the protrusion of the 1^{st} source/drain region contacts a side surface the 1^{st} inner spacer, and
wherein the protrusion of the 1^{st} source/drain region has a same thickness as the 1^{st} inner spacer in the 1^{st} direction.

3. The semiconductor device of claim 1 or 2, wherein the 1^{st} source/drain region comprises p-type impurities.

4. The semiconductor device of any one of claims 1 to 3, further comprising:
a plurality of 2^{nd} channel layers arranged in the 1^{st} direction above or below the 1^{st} channel layers;
a 2^{nd} source/drain region on the plurality of 2^{nd} channel layers;
a 2^{nd} gate structure comprising a 2^{nd} inner gate structure between two adjacent 2^{nd} channel layers among the plurality of 2^{nd} channel layers; and
a 2^{nd} inner spacer between the 2^{nd} inner gate structure and the 2^{nd} source/drain region,
wherein the 2^{nd} inner spacer has a same thickness as the 2^{nd} inner gate structure in the 1^{st} direction.

5. The semiconductor device of claim 4, wherein the 1^{st} source/drain region has a greater length than the 2^{nd} source/drain region in a 2^{nd} direction intersecting the 1^{st} direction.

6. The semiconductor device of any one of claims 1 to 3, wherein a top surface of the 1^{st} inner spacer is at a higher level than a top surface of the 1^{st} inner gate structure, and a bottom surface of the 1^{st} inner spacer is at a lower level than a bottom surface of the 1^{st} inner gate structure, in the 1^{st} direction.

7. The semiconductor device of any one of claims 1, 2, 3 and 6, wherein each of the two adjacent 1^{st} channel layers comprises a body structure and a fin structure which is formed at each lateral side of the body structure and penetrates into the 1^{st} source/drain region.

8. The semiconductor device of claim 7, wherein the body structure has a greater thickness than the fin structure in the 1^{st} direction.

9. The semiconductor device of claim 7 or 8, wherein the 1^{st} inner spacer is disposed between two vertically adjacent fin structures of the two adjacent 1^{st} channel layers.

10. The semiconductor device of any one of claims 1 to 3 or of any one of claims 6 to 9, wherein the 1^{st} inner spacer has a substantially rectangular shape.

11. The semiconductor device of any one of claims 1 to 3 or any one of claims 6 to 10, further comprising:
a plurality of 2^{nd} channel layers arranged in the 1^{st} direction above or below the 1^{st} channel layers;
a 2^{nd} source/drain region on the plurality of 2^{nd} channel layers;
a 2^{nd} gate structure comprising a 2^{nd} inner gate structure between two adjacent 2^{nd} channel layers among the plurality of 2^{nd} channel layers; and
a 2^{nd} inner spacer between the 2^{nd} inner gate structure and the 2^{nd} source/drain region,
wherein a top surface and a bottom surface of the 2^{nd} inner spacer are at same levels as a top surface and a bottom surface of the 2^{nd} inner gate structure, respectively, in the 1^{st} direction.

12. The semiconductor device of claim 11, wherein the 2^{nd} inner spacer has a different shape than the 1^{st} inner spacer.

13. The semiconductor device of claim 11 or 12, wherein the 1^{st} inner spacer is thicker than the 2^{nd} inner spacer in the 1^{st} direction.

14. The semiconductor device of any one of claims 11 to 13, wherein the 1^{st} source/drain region comprises p-type impurities, and the 2^{nd} source/drain region comprises n-type impurities.
